(19) Europäisches Patentamt
European Patent Office
Office européen des brevets

(11) **EP 4 199 118 A1**

(12) **DEMANDE DE BREVET EUROPEEN**

(43) Date de publication:
**21.06.2023 Bulletin 2023/25**

(51) Classification Internationale des Brevets (IPC):
***H01L 31/0216*** (2014.01) ***H01L 31/18*** (2006.01)

(21) Numéro de dépôt: **22215066.6**

(52) Classification Coopérative des Brevets (CPC):
**H01L 31/1804; H01L 31/02167; H01L 31/1864; H01L 31/1868**

(22) Date de dépôt: **20.12.2022**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **20.12.2021 FR 2114036**

(71) Demandeur: **Commissariat à l'énergie atomique et aux énergies alternatives**
**75015 Paris (FR)**

(72) Inventeurs:
• **ALBARIC, Mickaël**
**38054 GRENOBLE CEDEX 09 (FR)**
• **PELLETIER, David**
**38054 GRENOBLE CEDEX 09 (FR)**

(74) Mandataire: **Cabinet Camus Lebkiri**
**25 rue de Maubeuge**
**75009 Paris (FR)**

(54) **PROCÉDÉ D'ACTIVATION THERMIQUE D'UNE COUCHE DE PASSIVATION**

(57) Un aspect de l'invention concerne un procédé d'activation thermique d'une couche de passivation (10) disposée sur une cellule photovoltaïque (20). La cellule photovoltaïque (20) comprenant une première face (20a), une deuxième face (20b) opposée à la première face et des surfaces latérales (20c) reliant les première et deuxième faces. La couche de passivation (10) recouvre au moins une des surfaces latérales (20c) de la cellule photovoltaïque (20). Le procédé comprend une étape d'exposition de la première face (20a) à un rayonnement électromagnétique (30) émis par une source de rayonnement (40). Le rayonnement électromagnétique (30) est appliqué sur la première face (20a) selon une ligne. La ligne balaye une partie au moins de la première face (20a) et est orientée par rapport à la première face (20a) de sorte à obtenir une zone de surchauffe englobant une partie au moins de la couche de passivation (10).

[Fig. 1]

EP 4 199 118 A1

**Description**

**DOMAINE TECHNIQUE**

La présente invention est relative à la fabrication de modules photovoltaïques. L'invention concerne plus particulièrement un procédé d'activation thermique d'une couche de passivation disposée sur une ou plusieurs surfaces latérales d'une cellule photovoltaïque. Ce procédé d'activation thermique trouve une application particulièrement avantageuse avec des sous-cellules photovoltaïques obtenues par découpage de cellules photovoltaïques entières.

**ÉTAT DE LA TECHNIQUE**

Un module photovoltaïque comprend une multitude de cellules photovoltaïques identiques connectées en série et/ou en parallèle. Un format de module répandu comprend 60 cellules carrées (ou « pseudo-carrées »), de 156 mm de côté, réparties en six chaînes (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module).

Avec les dernières technologies de cellules photovoltaïques, notamment les technologies TopCON (pour « tunneling oxide passivated contact » en anglais), PERC (pour « passivated emitter and rear cell » en anglais) et SHJ (« silicon heterojunction »), le courant d'une cellule monofaciale de 156 mm x 156 mm en superficie atteint des valeurs élevées, de l'ordre de 9 A pour une irradiance solaire de 1000 W/m². Ces valeurs de courant sont augmentées d'environ 20 % lorsqu'on utilise une cellule bifaciale, du fait du rayonnement solaire diffus capté en face arrière de la cellule. Ce fort courant électrique circule dans les éléments d'interconnexion entre les cellules du module et occasionne des pertes résistives importantes.

Afin de réduire ces pertes résistives, une solution consiste à assembler des modules avec des cellules photovoltaïques de superficie plus faible, et donc de courant plus faible. Ces cellules de plus faible superficie sont généralement des fractions de cellule photovoltaïque communément appelées « sous-cellules » et obtenues par découpage de cellules photovoltaïques de pleine taille (ex. 156 mm x 156 mm).

La découpe d'une cellule photovoltaïque crée de nouveaux bords qui, à la différence de la face avant et de la face arrière de la cellule, ne sont pas recouverts par des couches de passivation. Par ailleurs, la découpe (au laser par exemple) est susceptible de créer des défauts et d'introduire des impuretés à proximité du plan de coupe. Ces défauts et impuretés diminuent la durée de vie des porteurs de charge libres en agissant comme centres de recombinaison des paires électron-trou, ce qui se traduit par une diminution du rendement de la cellule. Ce phénomène est particulièrement prononcé pour les cellules photovoltaïques à hétérojonction, qui possèdent par nature très peu de défauts de surface et où la création de quelques défauts localisés suffit à réduire les performances électriques de la cellule de manière significative.

Pour optimiser les performances des sous-cellules photovoltaïques, il est donc nécessaire de passiver également les bords nouvellement créés de ces sous-cellules.

Une technique consiste à former une couche de passivation en alumine ($Al_2O_3$) par dépôt de couches atomiques (ou ALD, pour « atomic layer déposition » en anglais) sur une ou plusieurs parois latérales des sous-cellules photovoltaïques. La demande internationale WO2020/127896 décrit par ailleurs la formation d'une couche de passivation par dépôt spatial de couches atomiques (SALD) simultanément sur plusieurs sous-cellules photovoltaïques.

Une fois la couche de passivation déposée, une étape dite « d'activation » de la passivation est généralement accomplie par recuit thermique pour améliorer de manière significative l'effet de passivation. En effet, ce recuit forme des charges fixes qui créent un effet de champ et fait diffuser des atomes d'hydrogène qui comblent des liaisons pendantes aux interfaces.

La demande internationale WO2020/220079 décrit le découpage d'une cellule photovoltaïque en plusieurs sous-cellules appelées « shingle » (car destinées à être interconnectées en se chevauchant légèrement, comme des tuiles ou des bardeaux sur un toit) et le dépôt d'une couche de passivation (par exemple en $Al_2O_3$) sur les bords découpés des sous-cellules. Le dépôt est suivi d'un recuit d'activation à 400 °C.

Enfin, l'article [« Low-thermal budget flash light annealing for Al2O3 surface passivation », D. K. Simon et al., Physica status solidi (RRL) - Rapid Research Letters, Vol. 9, No. 11, pp. 631-635, 2015] décrit le dépôt d'une couche de passivation en $Al_2O_3$ sur chacune des deux faces principales d'un substrat en silicium et un recuit par flash de lumière pour activer thermiquement les deux couches de passivation.

Le recuit est accompli en exposant les deux faces principales du substrat à des flashs de lumière (de durée égale à 1,8 ms) produits par une lampe au xénon. Lors de l'exposition, le substrat est placé dans une atmosphère de dihydrogène ($H_2$) chauffée à une température de 200 °C.

D'une manière générale, l'activation thermique d'une couche de passivation disposée sur une cellule photovoltaïque est d'autant plus efficace que la température du recuit est élevée. Cependant, la cellule photovoltaïque peut être dégradée si sa température excède une valeur seuil, typiquement de l'ordre de 250 °C pour une cellule à hétérojonction de silicium (SHJ) et de l'ordre de 500 °C pour une cellule à homojonction de silicium (par exemple de type TopCON ou PERC).

**RESUMÉ DE L'INVENTION**

Il existe un besoin d'activer thermiquement une couche de passivation disposée sur au moins une surface latérale d'une cellule photovoltaïque, tout en réduisant le risque de dégrader la cellule photovoltaïque.

Selon un premier aspect de l'invention, on tend à satisfaire ce besoin en prévoyant un procédé d'activation thermique d'une couche de passivation disposée sur une cellule photovoltaïque, la cellule photovoltaïque comprenant une première face, une deuxième face opposée à la première face et des surfaces latérales reliant les première et deuxième faces, la couche de passivation recouvrant au moins une des surfaces latérales de la cellule photovoltaïque, le procédé comprenant une étape d'exposition de la première face à un rayonnement électromagnétique émis par une source de rayonnement, le procédé d'activation thermique étant remarquable en ce que le rayonnement électromagnétique est appliqué sur la première face selon une ligne, en ce que la ligne balaye une partie au moins de la première face et en ce que la ligne est orientée par rapport à la première face de sorte à obtenir une zone de surchauffe englobant une partie au moins de la couche de passivation.

Par « activation thermique », on entend notamment la formation de charges fixes dans la couche de passivation (ces charges fixes créant un effet de champ qui repousse l'un des deux types de porteurs de charge libres vers le substrat de la cellule photovoltaïque) et/ou la saturation des liaisons pendantes en surface du substrat en silicium cristallin de la cellule photovoltaïque (qui sont responsables d'un grand nombre de recombinaisons de paires électron-trou).

De préférence, la première face comprend :

- un premier bord appelé bord d'attaque ;

- un deuxième bord appelé bord de fuite et opposé au premier bord ; et

- des troisième et quatrième bords reliant les premier et deuxième bords.

Dans un premier mode de mise en oeuvre du procédé d'activation, la couche de passivation recouvre la surface latérale bordée par le bord de fuite et la ligne comprend un segment de droite orienté perpendiculairement à une médiane de la première face, la médiane passant par le bord d'attaque et le bord de fuite.

Selon une variante de mise en oeuvre, la couche de passivation comprend une première portion recouvrant la surface latérale bordée par le bord de fuite et une deuxième portion recouvrant la surface latérale bordée par le bord d'attaque. La ligne balaye la première face dans un premier sens lors d'une première phase et dans un deuxième sens opposé lors d'une deuxième phase.

Dans un deuxième mode de mise en oeuvre, la couche de passivation comprend une première portion recouvrant la surface latérale bordée par le bord de fuite et une deuxième portion recouvrant la surface latérale bordée par l'un des troisième et quatrième bords. La ligne comprend un segment de droite incliné par rapport à une médiane de la première face d'un angle strictement inférieur à 90° en valeur absolue, la médiane passant par le bord d'attaque et le bord de fuite.

Dans un troisième mode de mise en oeuvre, la couche de passivation comprend une première portion recouvrant la surface latérale bordée par le troisième bord et une deuxième portion recouvrant la surface latérale bordée par le quatrième bord. La ligne est une ligne brisée comprenant un premier segment de droite incliné par rapport à une médiane de la première face d'un premier angle positif et un deuxième segment de droite incliné par rapport à la médiane d'un deuxième angle négatif, la médiane passant par le bord d'attaque et le bord de fuite, le premier angle et le deuxième angle étant inférieurs à 90° en valeur absolue, de préférence inférieurs à 45° en valeur absolue.

Selon un développement de ce troisième mode de mise en oeuvre, le premier angle et le deuxième angle sont compris entre 10° et 20° en valeur absolue.

Selon un autre développement, le premier angle et le deuxième angle sont égaux en valeur absolue.

Le procédé d'activation selon l'invention peut également présenter une ou plusieurs des caractéristiques ci-dessous, considérées individuellement ou selon toutes les combinaisons techniquement possibles :

- la cellule photovoltaïque et la source de rayonnement sont animées d'un mouvement relatif de translation ;

- la ligne balaye toute la superficie de la première face ;

- la densité surfacique d'énergie reçue en tout point de la première face est comprise entre 1 kJ/m$^2$ et 1000 kJ/m$^2$, avantageusement entre 10 kJ/m$^2$ et 100 kJ/m$^2$ ;

- le rayonnement électromagnétique présente une irradiance supérieure ou égale à 1 kW/m$^2$, de préférence comprise entre 100 kW/m$^2$ et 5000 kW/m$^2$ ;

- la cellule photovoltaïque et la source de rayonnement sont en mouvement relatif de translation à une vitesse de déplacement comprise entre 1 cm/s et 100 cm/s, de préférence supérieure ou égale à 2 cm/s ; et

- la ligne présente une largeur comprise entre 0,1 mm et 100 mm, de préférence comprise entre 1 mm et 10 mm.

Un deuxième aspect de l'invention concerne un procédé de fabrication de sous-cellules photovoltaïques passivées, comprenant les étapes suivantes :

- découper des cellules photovoltaïques pour former une pluralité de sous-cellules photovoltaïques, chaque sous-cellule photovoltaïque comprenant une première face, une deuxième face opposée à la première face et des surfaces latérales reliant les première et deuxième faces, au moins une des surfaces latérales de chaque sous-cellule photovoltaïque, dite additionnelle, résultant du découpage d'une cellule photovoltaïque ;

- déposer une couche de passivation sur au moins une surface latérale additionnelle des sous-cellules photovoltaïques ;

- activer thermiquement la couche de passivation des sous-cellules photovoltaïques en suivant un procédé d'activation thermique selon le premier aspect de l'invention.

De préférence, les cellules photovoltaïques sont découpées en demi-cellules ou en sous-unités de superficie inférieure à celle d'une demi-cellule.

**BRÈVE DESCRIPTION DES FIGURES**

D'autres caractéristiques et avantages de l'invention ressortiront clairement de la description qui en est donnée ci-dessous, à titre indicatif et nullement limitatif, en référence aux figures suivantes.

[Fig. 1] représente schématiquement un procédé d'activation thermique de couche de passivation selon un premier aspect de l'invention, ce procédé comprenant le balayage d'une cellule photovoltaïque par une ligne de rayonnement électromagnétique.

[Fig. 2] représente un premier mode de mise en oeuvre du procédé d'activation par balayage selon l'invention.

[Fig. 3] montre la température maximale atteinte dans l'épaisseur d'une cellule photovoltaïque pour chaque point d'une face exposée au rayonnement électromagnétique, au cours d'un procédé d'activation selon la figure 3.

[Fig. 4] représente un deuxième mode de mise en oeuvre du procédé d'activation par balayage selon l'invention.

[Fig. 5] montre la température maximale atteinte dans l'épaisseur d'une cellule photovoltaïque pour chaque point de la face exposée, au cours d'un procédé d'activation selon la figure 4.

[Fig. 6] représente un troisième mode de mise en oeuvre du procédé d'activation par balayage selon l'invention.

[Fig. 7] montre la température maximale atteinte dans l'épaisseur de la cellule photovoltaïque pour chaque point de la face exposée, au cours d'un procédé d'activation selon la figure 6.

[Fig. 8A] représente l'amplitude de la surchauffe dans une portion adjacente à un bord de fuite de la cellule photovoltaïque, en fonction de la vitesse de balayage du rayonnement électromagnétique.

[Fig. 8B] représente la largeur de la portion surchauffée en fonction de la vitesse de balayage du rayonnement électromagnétique.

[Fig. 9] représente les températures en deux points de la cellule photovoltaïque et la différence de température entre ces deux points, en fonction de la densité surfacique d'énergie apportée à la cellule photovoltaïque, lorsque la face de de la cellule photovoltaïque est entièrement balayée par le rayonnement électromagnétique.

[Fig. 10] représente la largeur de la portion surchauffée en fonction de la vitesse de balayage du rayonnement électromagnétique, pour différentes séries de calculs.

[Fig. 11A], [Fig. 11B] et [Fig. 11C] représentent des étapes d'un procédé de fabrication de sous-cellules photovoltaïques selon un deuxième aspect de l'invention.

Pour plus de clarté, les éléments identiques ou similaires sont repérés par des signes de référence identiques sur l'ensemble des figures.

## DESCRIPTION DÉTAILLÉE

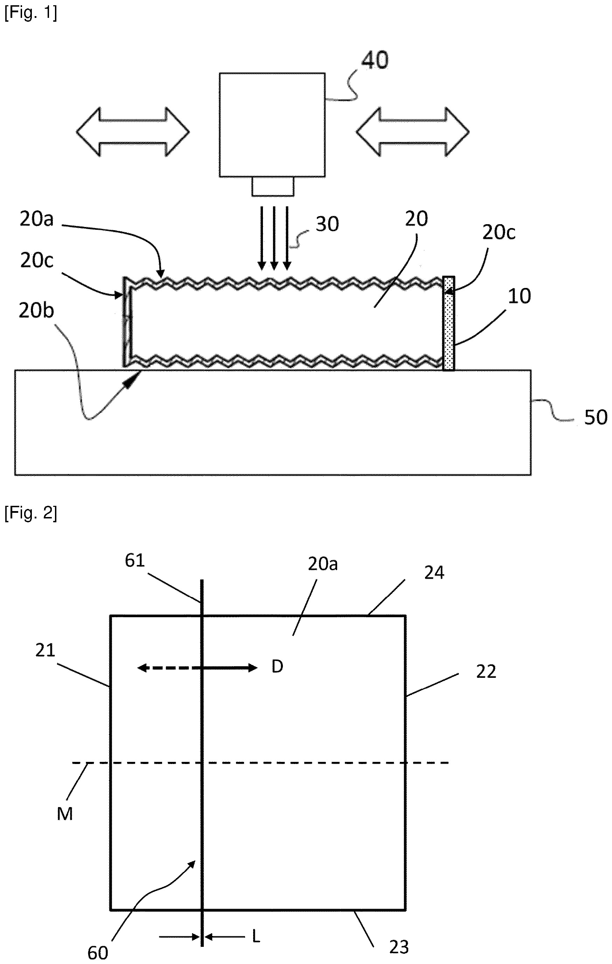

La figure 1 représente schématiquement un procédé d'activation thermique d'une couche de passivation 10 disposée sur une cellule photovoltaïque 20.

La cellule photovoltaïque 20 comprend une première face 20a, une deuxième face 20b opposée à la première face 20 et des surfaces latérales 20c reliant les première et deuxième faces 20a-20b.

La première face 20a et la deuxième face 20b peuvent être qualifiées de « principales » en raison de leur superficie bien supérieure à celles des surfaces latérales 20c. De préférence, elles sont de mêmes dimensions et s'étendent selon des plans parallèles entre eux. Elles peuvent également présenter une texturation de surface, comme cela est illustré sur la figure 1. L'une des première et deuxième faces 20a-20b constitue la face avant de la cellule photovoltaïque 20, c'est-à-dire la face destinée à être exposée au rayonnement solaire incident, tandis que l'autre constitue la face arrière de la cellule photovoltaïque 20.

Les première et deuxième faces 20a-20b de la cellule photovoltaïque 20 ont de préférence une forme rectangulaire ou globalement rectangulaire, par exemple carrée ou pseudo-carrée. Par « globalement rectangulaire », on entend qu'un ou plusieurs coins des première et deuxième faces 20a-20b peuvent être tronqués ou arrondis. Par exemple, dans une cellule photovoltaïque 20 au format pseudo-carré, les quatre coins des première et deuxième faces 20a-20b de la cellule photovoltaïque 20 sont tronqués ou arrondis.

Ainsi, la cellule photovoltaïque 20 a globalement la forme d'un parallélépipède rectangle. L'épaisseur de la cellule photovoltaïque 20 (mesurée perpendiculairement aux première et deuxième faces 20a-20b) est typiquement comprise entre 50 $\mu$m et 200 $\mu$m.

La couche de passivation 10 recouvre une ou plusieurs surfaces latérales 20c de la cellule photovoltaïque 20. Elle vise à augmenter la durée de vie des porteurs de charge libres dans la cellule photovoltaïque 20, en réduisant le nombre de recombinaisons de paires électron-trou en surface de la cellule photovoltaïque 20, et donc à augmenter le rendement de conversion de la cellule photovoltaïque 20. La couche de passivation 10 peut recouvrir toutes les surfaces latérales 20c. Elle peut également recouvrir une partie de la première face 20a et/ou une partie de la deuxième face 20b (typiquement des bandes attenantes aux surfaces latérales recouvertes).

La couche de passivation 10 est par exemple constituée d'alumine ($Al_2O_3$), de dioxyde de silicium ($SiO_2$), de nitrure de silicium ($Si_3N_4$) ou de nitrure de silicium amorphe hydrogéné (a-$Si_xN_y$ :H). Elle peut être formée par dépôt de couches atomiques (ALD) ou par dépôt chimique en phase vapeur (CVD), assisté ou non par plasma (PEALD ou PECVD). Elle peut également être obtenue par dépôt spatial de couches atomiques (SALD). La technique du dépôt spatial de couches atomiques est une variante de la technique ALD classique (dite « temporelle »). Dans cette variante, les différents gaz précurseurs permettant le dépôt du matériau sont séparés dans l'espace plutôt que dans le temps.

La couche de passivation 10 comprend de préférence des atomes d'hydrogène. L'hydrogène peut être apporté lors du dépôt de la couche ou après dépôt grâce à une étape d'implantation ionique (procédé basse température).

En référence à la figure 1, le procédé d'activation comprend une étape d'exposition de la première face 20a de la cellule photovoltaïque 20 à un rayonnement électromagnétique 30 émis par une source de rayonnement 40. Le rayonnement électromagnétique 30 est de préférence dirigé perpendiculairement à la première face 20a.

Le rayonnement électromagnétique 30 est, au moins en partie, absorbé par la cellule photovoltaïque 20 et converti en chaleur, ce qui permet d'activer thermiquement la couche de passivation 10.

Lors de l'étape d'exposition, aussi appelée étape d'irradiation, la cellule photovoltaïque 20 et la source de rayonnement 40 sont avantageusement animés d'un mouvement relatif de translation (autrement dit, l'un se déplace par rapport à l'autre). Par exemple, la cellule photovoltaïque 20 peut être placé sur un support 50 mobile en translation et la source 40 peut être fixe. Inversement, le support 50 de la cellule photovoltaïque 20 peut être fixe et la source 40 mobile. La cellule photovoltaïque 20 et la source 40 peuvent être également tous les deux mobiles, mais pas dans la même direction et à la même vitesse.

Le support 50 peut notamment être un porte-substrat ou un convoyeur capable de transporter plusieurs cellules photovoltaïques 20 simultanément.

Un tel mouvement de translation permet d'irradier une grande partie de la première face 20a de la cellule photovoltaïque 20 en utilisant une source de rayonnement 40 ayant une surface d'irradiation inférieure à la superficie de la première face 20a (cas d'un système laser notamment). Il permet également d'irradier plusieurs cellules photovoltaïques 20 successivement, ces cellules photovoltaïques étant par exemple disposées sur le même support 50. Dans ce cas, il pourra être considéré que les cellules photovoltaïques 20 défilent devant la source de rayonnement 40.

Le rayonnement électromagnétique 30 présente une irradiance E, appelée aussi éclairement énergétique ou densité surfacique de puissance lumineuse, qui est avantageusement supérieure ou égale à 1 kW/m$^2$, de préférence comprise entre 100 kW/m$^2$ et 5000 kW/m$^2$. L'irradiance E représente la puissance du rayonnement électromagnétique reçue par une unité de surface, cette unité de surface étant orientée perpendiculairement à la direction du rayonnement électromagnétique 30. Une telle irradiance permet de chauffer rapidement la cellule photovoltaïque 20 jusqu'à atteindre une température permettant l'activation thermique de la couche de passivation 10.

Afin d'activer thermiquement la couche de passivation 10 disposée sur la cellule photovoltaïque 20, il n'est pas obligatoire d'exposer la deuxième face 20b ou les surfaces latérales 20c de la cellule photovoltaïque 20. En revanche, la première face 20a peut être irradiée entièrement. De préférence, toutes les régions exposées de la première face 20a reçoivent le rayonnement électromagnétique 30 pendant la même durée de traitement t.

La source de rayonnement 40 peut être un système laser comprenant par exemple une ou plusieurs matrices de lasers, un ensemble de diodes électroluminescentes ou tout autre dispositif capable d'émettre un rayonnement électromagnétique d'une irradiance supérieure à 1 kW/m$^2$.

Le rayonnement électromagnétique 30 peut être monochromatique, c'est-à-dire ne présenter qu'une seule longueur d'onde, ou polychromatique, c'est-à-dire comporter plusieurs composantes (monochromatiques) de longueurs d'ondes différentes. Plus précisément, le rayonnement électromagnétique 30 présente au moins une longueur d'onde comprise entre 300 nm et 1200 nm (dans cette plage, le rayonnement est absorbé au moins en partie dans la cellule photovoltaïque 20).

Les figures 2, 4 et 6 représentent différents modes de mise en oeuvre du procédé d'activation de la couche de passivation 10.

La première face 20a (définie comme la face exposée au rayonnement électromagnétique 30) comprend :

- un premier bord 21 appelé bord d'attaque et défini comme étant le bord à passer en premier devant la source de rayonnement 40 ;

- un deuxième bord 22 appelé bord de fuite, opposé au premier bord 21 et défini comme étant le bord à passer en dernier devant la source de rayonnement 40 ; et

- des troisième et quatrième bords 23-24 dits transversaux (bords inférieur et supérieur sur les figures) qui relient les premier et deuxième bords 21-22.

Comme indiqué précédemment, la première face 20a de la cellule photovoltaïque 20 présente de préférence une forme rectangulaire ou globalement rectangulaire (angles tronqués ou arrondis). Le bord d'attaque 21 et le bord de fuite 22 sont ainsi parallèles entre eux, tout comme les bords transversaux 23-24.

D'une manière commune à tous les modes de réalisation, la source de rayonnement 40 est configurée de sorte que le rayonnement électromagnétique 30 soit appliqué à la première face 20a selon une ligne 60. Autrement dit, la surface de la cellule photovoltaïque 20 irradiée par la source de rayonnement 40 (appelée surface d'irradiation) à un instant donné du procédé d'activation est en forme de ligne. La ligne 60 présente une largeur L qui peut être comprise entre 0,1 mm et 100 mm, de préférence entre 1 mm et 10 mm.

La ligne 60 peut comprendre un ou plusieurs segments de droite 61, 61' 62a-62b. Les segments de droite peuvent être connectés, formant ainsi une ligne brisée, ou au contraire être disjoints. La ligne 60 est ainsi l'intersection d'un faisceau d'ondes électromagnétiques généré par la source de rayonnement 40 avec la surface de la cellule photovoltaïque 20, les rayons du faisceau étant contenus dans un ou plusieurs plans (sécants ou non).

La direction D du déplacement relatif entre la cellule photovoltaïque 20 et la source de rayonnement 40 est telle que la ligne 60 balaye une partie au moins de la première face 20a de la cellule photovoltaïque 20 lors de l'étape d'exposition. Le balayage par la ligne 60 peut commencer par le bord d'attaque 21 et se terminer par le bord de fuite 22. Il peut également commencer à une position située entre le bord d'attaque 21 et le bord de fuite 22 (autrement dit après que le bord d'attaque 21 soit passé devant la source de rayonnement 40) et se terminer par le bord de fuite 22.

La direction de déplacement D de la source de rayonnement 40 par rapport à la cellule photovoltaïque 20, aussi appelée direction de balayage D, est par exemple perpendiculaire au bord d'attaque 21 et au bord de fuite 22, comme cela est représenté sur les figures 2, 4 et 6.

La vitesse V du déplacement relatif entre la cellule photovoltaïque 20 et la source de rayonnement 40 est de préférence choisie de façon à traiter une cellule photovoltaïque 20 par balayage du rayonnement électromagnétique en un temps t court, typiquement compris entre 0,1 s et 30 s. La vitesse de déplacement V est avantageusement comprise entre 1 cm/s et 100 cm/s, et de préférence supérieure ou égale à 2 cm/s.

Ce procédé d'activation par balayage est simple et rapide à mettre en oeuvre. En faisant défiler en continu les cellules photovoltaïques 20 devant la source de rayonnement 40, le procédé d'activation peut être accompli à une cadence élevée, compatible avec les exigences de production industrielle des cellules photovoltaïques.

A titre d'exemple, en considérant une vitesse de déplacement V comprise entre 1 cm/s et 100 cm/s et des cellules photovoltaïques 20 dont les faces principales 20a-20b mesurent 156 mm par 156 mm, le temps de traitement t d'un cellule photovoltaïque 20 est compris entre 0,156 s et 15,6 s. Le nombre de cellules photovoltaïques 20 traitées par heure peut être compris entre 200 et 25000.

Comme montré ultérieurement au moyen de simulations thermiques, le balayage d'une ligne de rayonnement électromagnétique a pour effet de chauffer la cellule photovoltaïque 20 de manière non uniforme, contrairement à un four de recuit traditionnel ou à une exposition simultanée de toute la première face 20a de la cellule photovoltaïque (exposition dite une exposition « pleine plaque »). Plus précisément, la température de la cellule photovoltaïque 20 augmente très fortement dans une portion localisée près d'un ou plusieurs bords de la première face 20a.

Le procédé d'activation selon l'invention exploite ce phénomène de surchauffe locale pour activer la couche de passivation 10 disposée sur une ou plusieurs surfaces latérales 20c de la cellule photovoltaïque 20. La ligne 60 est orientée par rapport à la première face 20a de sorte à obtenir une zone de surchauffe qui englobe une partie au moins de la couche de passivation 10, et de préférence toute la couche de passivation 10. L'effet de passivation de la couche de passivation 10 peut être ainsi grandement améliorée tout en réduisant le risque de dégrader la cellule photovoltaïque 20.

Le procédé d'activation peut être caractérisé par les paramètres suivants :

- E : l'irradiance du rayonnement électromagnétique 30 (en kW/m$^2$) ;

- V : la vitesse de déplacement relatif entre la cellule photovoltaïque 20 et la source de rayonnement 40, aussi appelée vitesse de balayage du rayonnement électromagnétique (en cm/s) ;

- L : la largeur de la ligne 60 (en mm) ; et

- e : l'épaisseur de la cellule photovoltaïque 20 (en $\mu$m).

La densité surfacique d'énergie Q (en kJ/m$^2$), ou énergie surfacique, reçue en tout point de la face de la cellule photovoltaïque par rayonnement électromagnétique est définie par la relation suivante :

[Math. 1]

$$Q = (E * L)/(10 * V)$$

Les paramètres E, V et L sont de préférence choisis pour obtenir une densité surfacique d'énergie Q comprise entre 1 kJ/m$^2$ et 1000 kJ/m$^2$, avantageusement entre 10 kJ/m$^2$ et 100 kJ/m$^2$. Les plages de valeurs données ci-dessus pour l'irradiance E du rayonnement électromagnétique 30, la vitesse de balayage V et la largeur L de la ligne 60 sont suffisamment larges pour y parvenir.

Des simulations thermiques ont montré que les températures en différents points de la cellule photovoltaïque lors de l'étape d'exposition augmentent avec la densité surfacique d'énergie Q. Par ailleurs, pour une combinaison des paramètres E, V et L donnée, d'autres simulations thermiques ont montré que ces températures dépendent de l'épaisseur e de la cellule photovoltaïque. Plus l'épaisseur e de la cellule photovoltaïque est faible et plus les températures sont élevées, car la densité volumique d'énergie absorbée augmente. Tous les résultats de simulation présentés ci-après ont été obtenus avec une épaisseur de cellule e égale à 160 $\mu$m.

Dans un premier mode de mise en oeuvre illustré par la figure 2, la ligne 60 comprend un segment de droite 61 orienté perpendiculairement à une médiane M de la première face 20a de la cellule photovoltaïque 20. La médiane M est le segment de droite qui relie les milieux du bord d'attaque 21 et du bord de fuite 22. Elle est de préférence perpendiculaire au bord d'attaque 21 et au bord de fuite 22. La source de rayonnement 40 est avantageusement dimensionnée pour que la ligne 60 irradie toute la largeur de la cellule photovoltaïque 20.

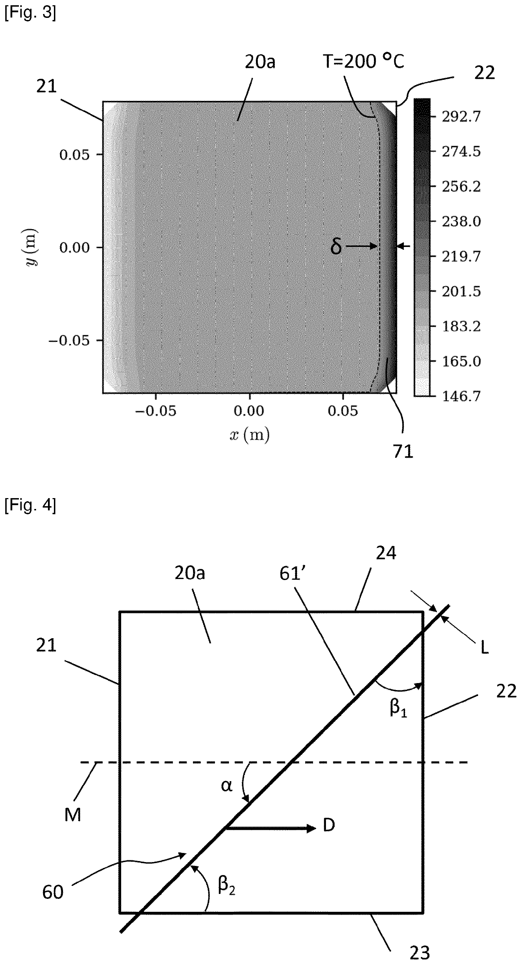

La figure 3 est une cartographie de la température maximale atteinte dans un cellule photovoltaïque 20 (dont les faces principales sont pseudo-carrées : 156 mm x 156 mm) au cours d'un procédé d'activation selon la figure 2. Elle a été obtenue au moyen d'une simulation thermique du procédé d'activation par balayage. Dans cette première simulation comme dans les suivantes, l'irradiance E du rayonnement électromagnétique est égale à 216 kW/m2, la vitesse de balayage V est égale à 2,48 cm/s et la largeur de la ligne 60 est égale à 6 mm. La courbe en traits pointillés représente l'isotherme T = 200 °C.

Cette cartographie montre que la température maximale de la cellule photovoltaïque 20 au cours de l'exposition est la plus faible à proximité du bord d'attaque 21 (exposé en premier au rayonnement électromagnétique 30), qu'elle augmente progressivement en se dirigeant vers le bord de fuite 22 pour atteindre (et se maintenir à) une température dite de plateau de l'ordre de 195 °C, puis augmente encore pour dépasser 200 °C dans une portion 71 adjacente au bord de fuite 22 (c.-à-d. le bord exposé en dernier au rayonnement électromagnétique 30). En dehors de cette portion 71 dite « surchauffée », la température maximale la cellule photovoltaïque 20 est donc inférieure à 200 °C.

La surchauffe locale près du bord de fuite 22 s'explique par la formation d'une couche limite thermique à l'avant du faisceau. Cette couche limite thermique est liée à la diffusion de chaleur et se propage dans la cellule photovoltaïque depuis le bord d'attaque 21 jusqu'au bord de fuite 22. A l'approche du bord de fuite 22, la chaleur ne peut plus diffuser vers l'avant du faisceau, ce qui provoque la surchauffe.

La figure 3 montre également que la température de la cellule photovoltaïque est égale à la température de plateau dans une majeure partie de la cellule photovoltaïque, cette partie étant ici qualifiée de « centrale » car disposée entre le bord d'attaque 21 et le bord de fuite 22 et contenant le point situé au centre de la face exposée 20a, en (x,y)=(0,0).

Le procédé d'activation selon le premier mode de mise en oeuvre est accompli lorsque la couche de passivation 10 recouvre la surface latérale 20c bordée par le bord de fuite 22 de la première face 20a, autrement dit lorsque la couche de passivation 10 longe le bord de fuite 22 (en pratique, la cellule est orientée par rapport à la direction de déplacement D pour que la surface latérale 20c recouverte par la couche de passivation 10 corresponde au bord de fuite 22).

Selon un développement du premier mode de mise en oeuvre (illustré par une flèche en traits pointillés sur la figure 2), la ligne 60 balaye la première face 20a du bord d'attaque 21 vers le bord de fuite 22 lors d'une première phase de l'étape d'exposition et du bord de fuite 22 vers le bord d'attaque 21 lors d'une deuxième phase de l'étape d'exposition. Le balayage de la ligne 60 dans les deux sens opposés de la direction de déplacement D permet d'obtenir une zone de surchauffe comprenant deux portions (disjointes) : l'une adjacente au bord de fuite 22 (la portion surchauffée 71 de la figure 3) et l'autre adjacente au bord d'attaque 21.

Cette variante de mise en oeuvre permet l'activation thermique d'une couche de passivation 10 comprenant une première portion recouvrant la surface latérale 20c bordée par le bord de fuite 22 et une deuxième portion recouvrant la surface latérale 20c bordée par le bord d'attaque 21 (autrement dit lorsque la couche de passivation 10 longe le bord d'attaque 21 et le bord de fuite 22).

Dans un deuxième mode de mise en oeuvre représenté par la figure 4, la ligne 60 comprend un segment de droite 61' incliné par rapport à la médiane M d'un angle $\alpha$ (non-nul) strictement inférieur à 90° en valeur absolue, et de préférence compris entre 30° et 60° en valeur absolue. L'angle $\alpha$ désigne le plus petit angle mesurable entre la ligne 60 et la médiane M. Il peut être positif ou négatif.

L'inclinaison de la ligne 60 par rapport à la médiane M a pour effet de déplacer une partie au moins de la surchauffe vers l'un des deux bords transversaux 23-24 de la première face 20a.

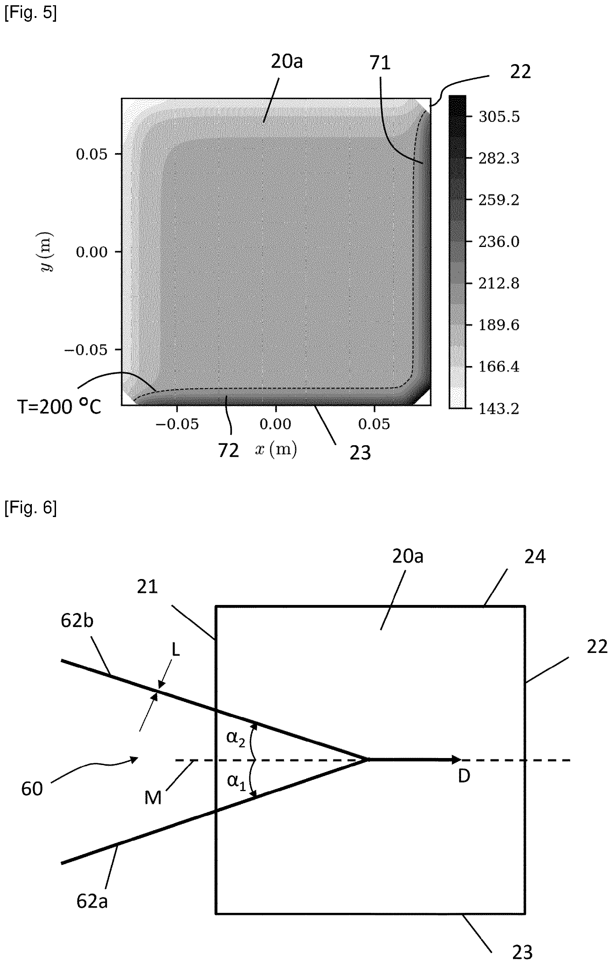

La figure 5 est une autre cartographie de la température maximale atteinte dans la cellule photovoltaïque, obtenue par simulation thermique du procédé d'activation selon la figure 4 en prenant pour exemple un angle $\alpha$ positif et égal à 45°.

Dans cet exemple, la surchauffe (T>200 °C) se produit dans la portion 71 adjacente au deuxième bord 22 (bord de fuite) et dans une portion 72 adjacente au troisième bord 23 (bord transversal inférieur). La ligne 60 forme avec chacun de ces deux bords 22, 23 un angle $\beta_1$, $\beta_2$ égal à 45° (cf. Fig.4).

Le procédé d'activation selon le deuxième mode de mise en oeuvre est accompli lorsque la couche de passivation 10 comprend une première portion recouvrant la surface latérale 20c bordée par le bord de fuite 22 et une deuxième portion recouvrant la surface latérale 20c bordée par l'un des bords transversaux 23-24 (autrement dit lorsque la couche de passivation 10 longe le bord de fuite 22 et l'un des bords transversaux 23-24).

La figure 6 représente un troisième mode de mise en oeuvre du procédé d'activation dans lequel la ligne 60 est une ligne brisée. La ligne 60 comprend un premier segment de droite 62a incliné par rapport à la médiane M d'un premier angle (strictement) positif $\alpha_1$ et un deuxième segment de droite 62b incliné par rapport à la médiane M d'un deuxième angle (strictement) négatif $\alpha_2$. Le premier angle $\alpha_1$ et le deuxième angle $\alpha_2$ sont des angles non-nuls inférieurs à 90° en valeur absolue, de préférence inférieurs à 45° en valeur absolue. La ligne 60 présente alors une forme de flèche (ou chevron).

Une ligne 60 en forme de flèche permet de déplacer au moins en partie la surchauffe du bord de fuite 22 vers les deux bords transversaux 23-24 de la première face 20a, au lieu d'un seul de ces bords dans le deuxième mode de mise en oeuvre (Figs.4-5).

Chacun des angles $\alpha_1$ et $\alpha_2$ est de préférence compris entre 10° et 20 ° en valeur absolue. La surchauffe se situe alors presque exclusivement le long des deux bords transversaux 23-24.

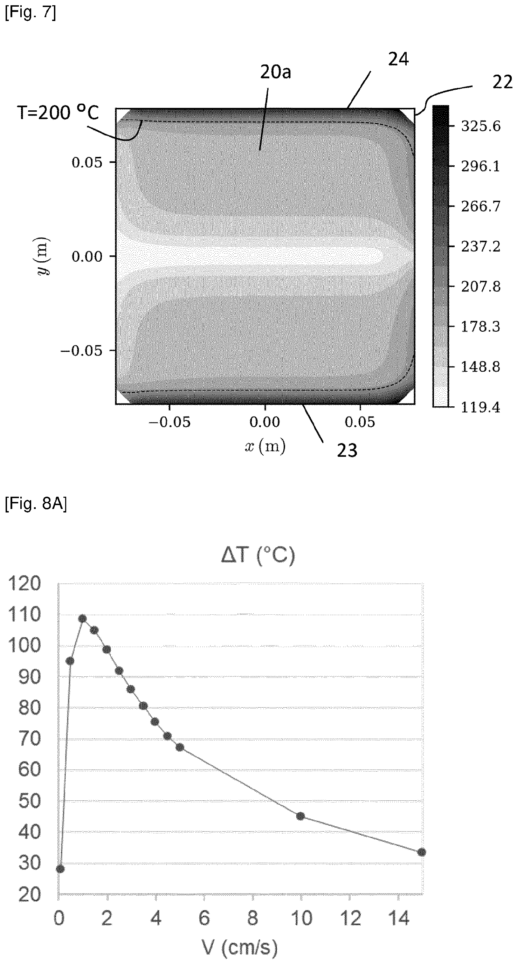

La figure 7 montre à titre d'exemple la température maximale dans la cellule photovoltaïque 20 obtenue par simulation thermique du procédé d'activation selon la figure 6, lorsque les angles $\alpha_1$ et $\alpha_2$ valent tous les deux 20°.

Le procédé d'activation selon le troisième mode de mise en oeuvre est accompli lorsque la couche de passivation 10 comprend une première portion recouvrant la surface latérale 20c bordée par le troisième bord 23 et une deuxième portion recouvrant la surface latérale 20c bordée par le quatrième bord 24 (autrement dit lorsque la couche de passivation 10 longe les deux bords transversaux 23-24).

Le premier angle $\alpha_1$ et le deuxième angle $\alpha_2$ peuvent ne pas être égaux en valeur absolue. Néanmoins, lorsqu'ils sont égaux, l'échauffement de la cellule photovoltaïque 20 est symétrique, comme illustré par la cartographie de température de la figure 7. Cela permet aux deux portions de la couche de passivation 10 d'être activées de la même façon.

La figure 8A est un graphique représentant l'amplitude $\Delta T$ de la surchauffe en fonction de la vitesse de balayage V du rayonnement électromagnétique. L'amplitude $\Delta T$ de la surchauffe correspond à la différence de températures entre le point le plus chaud dans la portion surchauffée 71 et le point situé au centre de la face exposée, en (x,y)=(0,0).

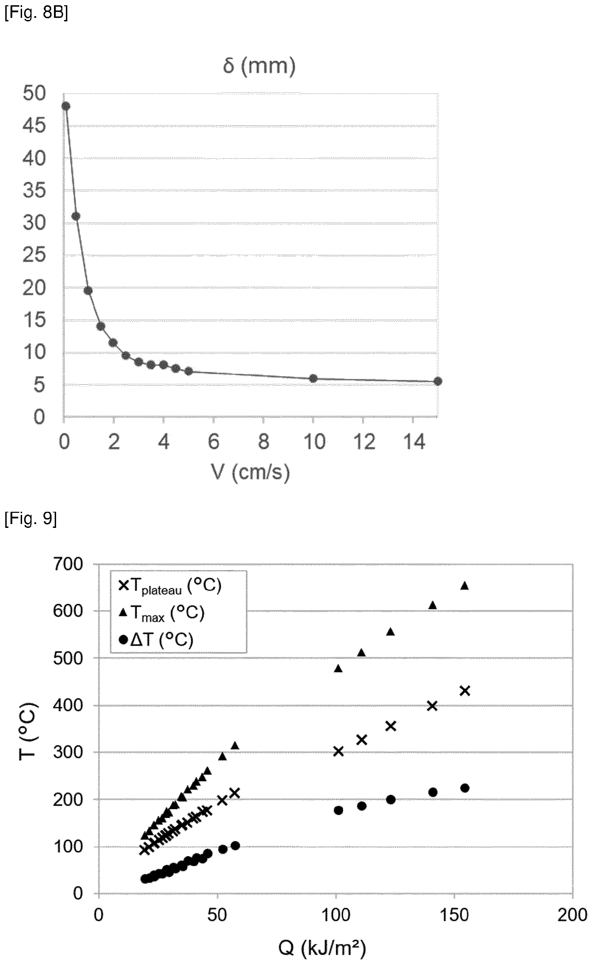

La figure 8B est un graphique représentant la largeur $\delta$ de la portion surchauffée 71 en fonction de la vitesse de balayage V du rayonnement électromagnétique. La largeur $\delta$ de la portion surchauffée 71 est mesurée depuis le bord de fuite 22 de la cellule photovoltaïque 20, perpendiculairement à ce bord et sur la médiane M de la première face 20a (à y=0).

Ces deux figures montrent que, pour une densité surfacique d'énergie donnée (ici 60 kJ/m$^2$), l'amplitude $\Delta T$ de la surchauffe et la largeur $\delta$ de la portion surchauffée 71 diminuent lorsque la vitesse de balayage augmente (à partir d'une vitesse de balayage d'environ 2 cm/s pour l'amplitude $\Delta T$).

Les résultats de simulation thermique, notamment ceux de la figure 8B, mettent en évidence que la largeur $\delta$ de la portion surchauffée 71 est principalement gouvernée par la vitesse de balayage V. La largeur $\delta$ de la portion surchauffée 71 peut être exprimée par une loi de puissance de la forme suivante :

[Math. 2]

$$\delta = aV^b$$

où V est la vitesse de balayage et a et b sont des premier et deuxième coefficients (et plus particulièrement des nombres réels).

La figure 9 montre les résultats d'autres simulations thermiques du procédé d'activation selon la figure 2, accomplies avec la même cellule photovoltaïque mais en faisant varier l'irradiance E du rayonnement électromagnétique entre 155 kW/m$^2$ et 237 kW/m$^2$ et la vitesse de balayage V entre 0,92 cm/s et 4,82 cm/s. La ligne 60 balaye toute la superficie de la première face 20a de la cellule photovoltaïque. La température de plateau $T_{plateau}$ au centre de la cellule photovoltaïque (en x = y = 0), la température maximale $T_{max}$ atteinte au bord de fuite 22 et la différence de température $\Delta T$ entre la température maximale $T_{max}$ et la température de plateau $T_{plateau}$ ($\Delta T = T_{max} - T_{plateau}$) sont représentées en fonction de la densité surfacique d'énergie Q résultant des paramètres de simulation choisis.

On constate que la température de plateau $T_{plateau}$ au centre de la cellule photovoltaïque (en x = y = 0) et la température maximale $T_{max}$ augmentent avec la densité surfacique d'énergie Q apportée à la cellule photovoltaïque 20.

Dans le procédé d'activation par balayage selon l'invention, il est choisi de préférence une valeur de densité surfacique d'énergie Q la plus élevée possible tout en conservant une température de plateau $T_{plateau}$ inférieure ou égale à la température seuil à partir de laquelle la cellule photovoltaïque est susceptible d'être dégradée. Cette température seuil est appelée ci-après « température de dégradation de la cellule photovoltaïque » et peut être comprise entre 200 °C et 500 °C selon le type et la constitution de la cellule photovoltaïque. Pour déterminer la densité surfacique d'énergie Q, il est avantageusement tenu compte de l'épaisseur e et de l'environnement de la cellule photovoltaïque (température ambiante, échanges convectifs...).

Une fois la densité surfacique d'énergie Q déterminée, les paramètres E, V et L sont déterminés afin d'assurer une mise en oeuvre optimale du procédé d'activation. Une vitesse de balayage V élevée permet par exemple de réduire la durée de traitement t et la largeur $\delta$ de la portion surchauffée 71. D'une manière générale, on cherche à obtenir une largeur $\delta$ la plus petite possible (pour limiter une éventuelle dégradation de la cellule photovoltaïque) mais néanmoins suffisante pour englober la couche de passivation 10, tout en garantissant une amplitude $\Delta T$ de surchauffe qui permette d'activer efficacement la couche de passivation 10. La largeur $\delta$ recherchée est de préférence comprise entre l'épaisseur de la couche de passivation 10 et 3 mm. La vitesse de balayage V est avantageusement choisie supérieure ou égale à 2 cm/s.

Une campagne de simulations thermiques a été menée afin de déterminer le premier coefficient a et le deuxième coefficient b de la relation δ(V) (cf. Math. 2). La campagne de simulation comprend plusieurs séries de calculs effectuées en prenant différentes valeurs pour les paramètres Q, E, V, L et e du procédé d'activation. Ces valeurs sont données par le tableau 1 ci-dessous pour chacune des séries.

[Tableau 1]

| Série | Q (kJ/m$^2$) | V (cm/s) | E (kW/m$^2$) | L (mm) | e (μm) |
|---|---|---|---|---|---|
| Q1 | 60 | de 0,1 à 100 | de 10 à 10000 | 6 | 160 |
| Q2 | 10 | de 0,1 à 100 | de 1,67 à 1670 | 6 | 160 |
| Q3 | 200 | de 0,1 à 100 | de 33,3 à 33333 | 6 | 160 |
| L1 | 60 | de 0,1 à 100 | de 3 à 3000 | 20 | 160 |
| L2 | 60 | de 0,1 à 100 | de 60 à 60000 | 1 | 160 |
| e1 | 52,3 | 2,48 | 216 | 6 | de 60 à 160 |
| M1 | de 19,3 à 155 | de 0,92 à 4,82 | de 155 à 237 | 6 | 160 |

Dans chacune des séries 'Q1', 'Q2', 'Q3', 'L1' et 'L2', il est fait varier la vitesse de balayage V entre 0,1 cm/s à 100 cm/s. L'irradiance E est ajustée en fonction de la vitesse V selon la relation Math. 1 ci-dessus afin d'obtenir la valeur de densité Q indiquée. Pour ces cinq séries, différentes valeurs de coefficients a et b ont donc été obtenues par régression linéaire (dans un espace logarithmique).

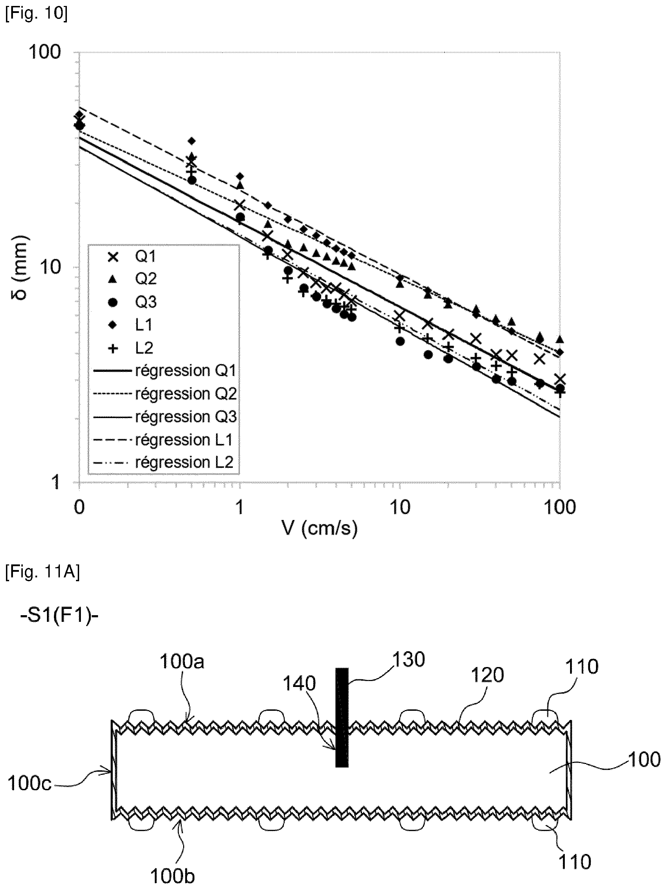

La figure 10 montre les résultats de ces cinq séries de calculs et les régressions linéaires associées. Les valeurs correspondantes des coefficients a et b, ainsi que l'erreur relative maximale entre les valeurs de δ observées dans les simulations et celles prédites par régression linéaire, sont données dans le tableau 2 ci-dessous.

[Tableau 2]

| Série | a | b | Erreur (%) |
|---|---|---|---|
| Q1 | 16,2 | -0,393 | 31 |
| Q2 | 19,6 | -0,343 | 25 |
| Q3 | 13,9 | -0,418 | 27 |
| L1 | 22,8 | -0,388 | 23 |
| L2 | 14,2 | -0,406 | 26 |

Les valeurs des coefficients a et b sont données pour V en cm/s et δ en mm.

Pour les cinq séries, le premier coefficient a varie entre 13 et 23 environ, le deuxième coefficient b varie entre -0,34 et -0,42 environ et l'erreur relative maximale est inférieure à 33 %.

L'ajustement des coefficients a et b en fonction des paramètres Q et L peut être réalisé empiriquement ou à l'aide d'autres simulations numériques.

De manière générale, le premier coefficient a peut être compris entre 0 et 1000, de préférence entre 5 et 50, et le deuxième coefficient b peut être compris entre -10 et 0, de préférence entre -1 et -0,1.

La série de calculs 'e1' montre l'influence de l'épaisseur e de la cellule photovoltaïque 20, dans un procédé d'activation de référence. Pour une épaisseur e variant de 60 μm à 160 μm, la largeur δ de la portion surchauffée varie de 10 %. La relation Math. 2 définie pour une valeur e donnée peut donc être raisonnablement utilisée pour une autre épaisseur comprise dans la gamme 60 μm-160 μm. Alternativement, les coefficients a et b peuvent être ajustés en fonction de l'épaisseur e de la cellule photovoltaïque.

Enfin, la série 'M1' regroupe des simulations correspondant à différentes configurations du procédé d'activation testées expérimentalement. Dans ces essais, la densité d'énergie Q est comprise entre 19,3 kJ/m$^2$ et 155 kJ/m$^2$. L'erreur relative entre les valeurs de largeur δ simulées dans la série 'M1' et celles calculées par régression linéaire en utilisant les coefficients a et b obtenus pour la série 'Q1' (Q = 60 kJ/m$^2$) est inférieure à 15 %. Ce résultat confirme que pour les valeurs envisagées de densité d'énergie Q et de vitesse de balayage V, l'ajustement des coefficients a et b en fonction de la densité d'énergie Q ne peut apporter qu'un gain faible sur la détermination de largeur δ de la portion surchauffée 71.

Le procédé d'activation décrit ci-dessus est applicable quels que soient le type, la forme et les dimensions de la cellule photovoltaïque 20. En particulier, il est applicable aussi bien à des cellules photovoltaïques de pleine taille (par exemple au format carré ou pseudo carré 156 mm x 156 mm), dont les bords n'auraient pas été (ou pas suffisamment) passivé, qu'à des fractions (ou morceaux) de cellules photovoltaïques, appelées ci-après sous-cellules et obtenues par découpage.

La cellule photovoltaïque 20 peut être une cellule à hétérojonction de silicium (SHJ), une cellule dite « tandem » comprenant une cellule à hétérojonction de silicium et une cellule à pérovskites empilées l'une sur l'autre ou une cellule à homojonction de silicium, par exemple de type PERT (pour « passivated emitter and rear totally diffused » en anglais) ou TOPCon (pour « tunnel oxide passivated contact » en anglais).

Une cellule SHJ comprend du silicium amorphe qui est connu pour se dégrader au-delà d'une température seuil. Cette température seuil, dite de dégradation du silicium amorphe, peut être comprise entre 190 °C et 320 °C suivant le mode de dépôt du silicium amorphe notamment (on parle de cellule « basse température »). Elle est par exemple égale à 220 °C.

Dans le cas d'une cellule SHJ, les paramètres E, V et L du procédé d'activation sont préférentiellement choisis de sorte que la température de plateau $T_{plateau}$ (atteinte dans une majeure partie de la première face 20a et notamment au centre de la première face 20a sur les figures 3 et 5 ou au centre des moitiés supérieure et inférieure de la première face 20a sur la figure 7) soit inférieure ou égale à une température de dégradation de la cellule SHJ, et de préférence inférieure ou égale à 220 °C. La température de dégradation de la cellule SHJ est de préférence égale à la température de dégradation du silicium amorphe. Toutefois, un autre matériau pourrait limiter la température de dégradation de la cellule SHJ.

Les paramètres E, V et L sont en outre avantageusement choisis de sorte que la température maximale $T_{max}$ (atteinte au bord où se situe par la couche de passivation 10) soit comprise entre 200 °C et 350 °C. Une portion de cellule SHJ peut supporter une température maximale $T_{max}$ supérieure à la température de dégradation seulement pendant un temps d'exposition donné. Par exemple, à 280 °C, la cellule SHJ n'est pas dégradée si le temps d'exposition est inférieur à 30 s.

Une cellule à homojonction de silicium (PERC, TOPCon...) peut supporter des températures plus élevées qu'une cellule SHJ (on parle de cellule « haute température »). La température de dégradation d'une cellule à homojonction est généralement comprise entre 400 °C et 500 °C. Les paramètres E, V et L du procédé d'activation sont alors préférentiellement choisis de sorte que la température de plateau $T_{plateau}$ soit inférieure ou égale à cette température de dégradation, et de préférence inférieure ou égale à 400 °C. Les paramètres E, V et L sont en outre avantageusement choisis de sorte que la température maximale $T_{max}$ soit comprise entre 200°C et 800 °C. A nouveau, à chaque valeur de température maximale $T_{max}$ supérieure à la température de dégradation est associée une valeur maximale de temps d'exposition.

A l'inverse, une cellule tandem peut supporter des températures plus faibles qu'une cellule SHJ. La température de dégradation d'une cellule tandem est d'environ 120 °C. Les paramètres E, V et L du procédé d'activation sont alors préférentiellement choisis de sorte que la température de plateau $T_{plateau}$ soit inférieure ou égale à la température de dégradation de la cellule tandem, soit inférieure ou égale à 120 °C. Les paramètres E, V et L sont en outre avantageusement choisis de sorte que la température maximale $T_{max}$ soit comprise entre 100 °C et 200 °C. A nouveau, à chaque valeur de température maximale $T_{max}$ supérieure à la température de dégradation (ici 120 °C) est associée une valeur maximale de temps d'exposition (par exemple, quelques secondes à 200 °C).

Quel que soit le type de cellule photovoltaïque, l'étape d'exposition au rayonnement électromagnétique peut comprendre plusieurs phases de balayage successives, par exemple en faisant défiler la cellule photovoltaïque 20 plusieurs fois devant la même source de rayonnement 40 (grâce notamment à un parcours en boucle), en multipliant le nombre de source de rayonnement électromagnétique 40 ou en effectuant plusieurs aller-retours avec la même ligne 60 de rayonnement électromagnétique. Plusieurs phases de balayage successives permettent de cumuler le temps d'exposition de la couche de passivation à la température $T_{max}$ (aussi appelée température d'activation thermique), et donc de maximiser l'effet de passivation. Deux phases de balayage successives sont avantageusement espacées (dans le temps) par une phase de refroidissement de la cellule photovoltaïque. Le nombre de phases de balayage dépend du temps d'exposition total souhaité.

Etant donné que la température d'activation pour une cellule SHJ ou une cellule tandem est plus faible que celle d'une cellule à homojonction, le temps d'exposition de la cellule SHJ ou de la cellule tandem devrait être plus important que celui de la cellule à homojonction. La cellule SHJ et la cellule tandem sont donc plus susceptibles d'être exposées plusieurs fois de suite.

Les figures 11A à 11C représentent un mode de mise en oeuvre préférentiel d'un procédé de fabrication de sous-cellules photovoltaïques selon un deuxième aspect de l'invention. Une sous-cellule photovoltaïque désigne ici une fraction ou un morceau d'une cellule photovoltaïque de pleine taille, aussi qualifiée de cellule photovoltaïque « entière ». Les sous-cellules photovoltaïques sont par exemple destinées à la fabrication de modules photovoltaïques ayant des pertes résistives faibles comparées à celles des modules photovoltaïques classiques (composés de cellules photovoltaïques entières).

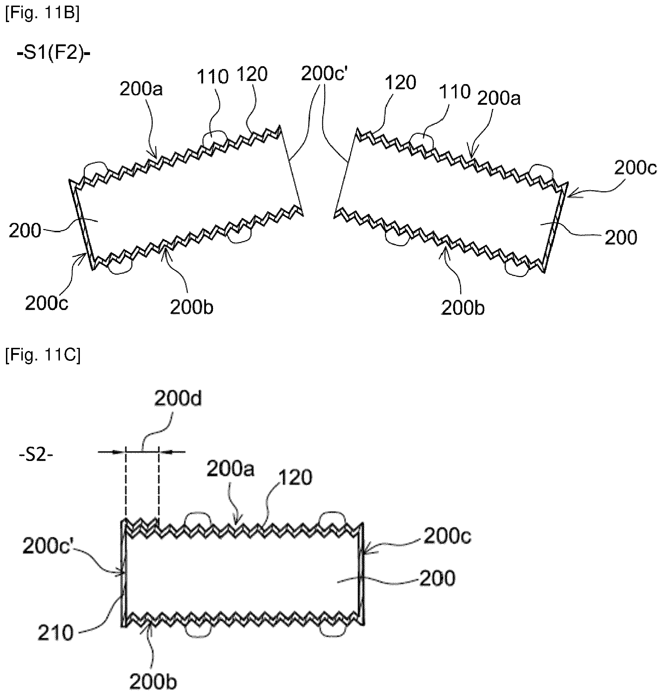

Ce procédé de fabrication comprend une étape S1 consistant à découper des cellules photovoltaïques 100 de pleine taille en une pluralité de sous-cellules 200 (cf. Figs.11A-11B) et une étape S2 de passivation des sous-cellules 200 (cf. Fig.11C). Dans un souci de clarté, seule une cellule photovoltaïque 100 et une sous-cellule 200 ont été représentées (en vue de coupe) sur les figures 11A et 11C respectivement.

Les cellules photovoltaïques 100 ont été préalablement fabriquées à partir de substrats semi-conducteurs, par exemple en silicium cristallin. Ces substrats ont été initialement découpés dans un lingot de silicium, puis ont été soumis à plusieurs étapes de fabrication (par exemple des étapes de structuration de surface, dopage, recuit, passivation, sérigraphie...), mais aucune autre étape de découpage.

Les cellules photovoltaïques 100 comprennent chacune une première face 100a, une deuxième face 100b opposée à la première face 100a et des surfaces ou parois latérales 100c reliant la première face 100a et la deuxième face 100b.

De préférence, les cellules photovoltaïques 100 sont prêtes à être interconnectées en une chaîne de cellules. Elles sont munies sur la première face 100a et/ou sur la deuxième face 100b d'une ou plusieurs métallisations 110 destinées à collecter les porteurs de charge photogénérés et à recevoir des éléments d'interconnexion, par exemple des fils ou rubans métalliques. Les métallisations 110 sont de préférence des pistes électriquement conductrices appelées « busbars ». Les busbars 110 peuvent relier électriquement des doigts de collecte (non représentés sur la figure 11A) répartis sur toute la superficie de la première face 100a et/ou de la deuxième face 100b. L'une des première et deuxième faces 100a-100b (la face arrière) des cellules photovoltaïques 100 peut aussi être entièrement métallisée. Dans une variante de mise en oeuvre, les cellules photovoltaïques 100 sont dépourvues de busbars 110 mais comportent uniquement des doigts de collecte.

La première face 100a et la deuxième face 100b de chaque cellule photovoltaïque 100 présentent avantageusement une couche de passivation 120. Cette couche de passivation 120 rend inactifs les défauts de surface de la cellule photovoltaïque 100 et améliore la durée de vie des porteurs de charge photogénérés. De préférence, la couche de passivation 120 recouvre également les surfaces latérales 100c de la cellule photovoltaïque 100.

Dans ce mode de mise en oeuvre préférentiel, le découpage de chaque cellule photovoltaïque 100 s'effectue en deux opérations successives F1 et F2, illustrées respectivement par les figures 11A et 11B.

L'opération F1 est une opération dite d'amorçage de la découpe qui consiste à exposer l'une des première et deuxième faces de la cellule photovoltaïque 100 (la première face 100a dans l'exemple de la figure 11A) à un laser 130 afin de former une tranchée 140. La profondeur de la tranchée 140 est strictement inférieure à l'épaisseur de la cellule photovoltaïque 100. La profondeur de la tranchée 140 est de préférence comprise entre 50 $\mu$m et 150 $\mu$m, alors que l'épaisseur de la cellule photovoltaïque 100 est typiquement comprise entre 150 $\mu$m et 200 $\mu$m.

Pour limiter l'endommagement de la cellule de part et d'autre de la tranchée 140, le laser 130 est avantageusement pulsé, les impulsions ayant une durée comprise entre $10^{-6}$ s et $10^{-15}$ s.

La formation de la tranchée 140 au moyen du laser 130 crée une zone de fragilité qui facilite le clivage mécanique de la cellule, lors de l'opération F2 (cf. Fig.11B). Le clivage mécanique s'effectue dans le plan de la tranchée 140, au départ de celle-ci, de préférence en exerçant des forces identiques de part et d'autre de la tranchée 140.

Les cellules photovoltaïques 100 sont de préférence découpées en deux sous-cellules 200 de même superficie (cf. Fig.11B), alors appelées « demi-cellules », ou en sous-unités de superficie inférieure à celle d'une demi-cellule, typiquement en trois, quatre, cinq ou six sous-cellules 200 de même superficie (les sous-cellules 200 sont alors des tiers, quarts, cinquièmes ou sixièmes de cellule). La découpe des cellules photovoltaïques 100 peut être entièrement automatisée.

Chaque sous-cellule 200 comprend une première face 200a et une deuxième face 200b, correspondant respectivement à une partie de la première face 100a et à une partie de la deuxième face 100b de la cellule photovoltaïque 100 dont la sous-cellule 200 est originaire. Chaque sous-cellule 200 peut en outre présenter une ou plusieurs surfaces latérales 200c correspondant chacune à tout ou partie d'une surface latérale 100c de la cellule photovoltaïque 100. La première face 200a, la deuxième face 200b et les surfaces latérales 200c des sous-cellules 200 sont donc avantageusement recouvertes de la couche de passivation 120.

À l'instar des cellules photovoltaïques 100, les sous-cellules 200 sont prêtes à être interconnectées. Une partie des métallisations 110 de la cellule photovoltaïque 100 est présente sur la première face et/ou sur la deuxième face de chaque sous-cellule 200.

Chaque sous-cellule 200 comprend également une ou plusieurs surfaces latérales additionnelles 200c' résultant du découpage de la cellule photovoltaïque 100. Ces surfaces latérales additionnelles 200c' constituent des zones où le matériau semiconducteur (ex. silicium) a été mis à nu. Autrement dit, ces surfaces latérales additionnelles 200c' sont dépourvues de couche de passivation, à la différence de la première face 200a, de la deuxième face 200b et des (éventuelles) autres surfaces latérales 200c de la sous-cellule 200. Par exemple, lorsqu'une cellule photovoltaïque 100 est découpée en quatre bandes de cellule parallèles, deux bandes de cellule présentent deux bords parallèles non passivés, et deux autres bandes de cellule présentent un seul bord non passivé.

En référence à la figure 11C, le procédé de fabrication comprend ensuite une étape S2 de passivation d'au moins un bord découpé des sous-cellules 200, et de préférence de tous les bords découpés. Cette étape vise à neutraliser les défauts de la surface latérale additionnelle 200c' correspondant audit bord découpé, et de préférence de toutes les surfaces latérales additionnelles 200c'. Ainsi, il est possible de limiter la diminution du rendement photovoltaïque des sous-cellules 200 qui est liée à la génération de nouveau(x) bord(s) par découpage.

L'étape S2 de passivation comprend une sous-étape de dépôt d'une couche de passivation 210 sur ladite au moins une surface latérale additionnelle 200c' des sous-cellules 200 et une sous-étape d'activation de la couche de passivation 210 des sous-cellules 200.

La couche de passivation 210 est par exemple constituée d'alumine ($Al_2O_3$), de dioxyde de silicium ($SiO_2$), de nitrure de silicium ($Si_3N_4$) ou de nitrure de silicium amorphe hydrogéné (a-$Si_xN_y$ :H). Elle peut être formée par dépôt de couches atomiques (ALD) ou par dépôt chimique en phase vapeur (CVD), assisté ou non par plasma (PEALD ou PECVD). Elle peut également être obtenue par dépôt spatial de couches atomiques (SALD).

Le dépôt de la couche de passivation 210 peut être réalisé sur plusieurs sous-cellules 200 simultanément, grâce notamment au procédé de passivation décrit dans la demande internationale WO2020/127896.

L'étape S2 de passivation peut également comprend une sous-étape d'implantation d'ions hydrogène dans la couche de passivation 210, après son dépôt et avant son activation.

L'activation de la couche de passivation 210 des sous-cellules 200 est accomplie au moyen du procédé d'activation décrit précédemment, par exemple en faisant défiler les sous-cellules 200 sous la source de rayonnement 40.

Lorsque les sous-cellules 200 sont des demi-cellules, chaque sous-cellule 200 ne comprend qu'un bord à passiver. Le procédé d'activation thermique selon la figure 2 est avantageusement employé (en orientant chaque sous-cellule 200 de sorte que le bord à passiver corresponde au bord de fuite).

Lorsque les sous-cellules 200 sont des quarts de cellules, obtenus par découpage d'une cellule photovoltaïque 100 selon une première direction et une deuxième direction perpendiculaire, chaque sous-cellule 200 comprend deux bords adjacents à passiver. Le procédé d'activation thermique selon la figure 4 est avantageusement employé.

Lorsque les sous-cellules 200 sont des bandes de cellules, obtenues par découpage d'une cellule photovoltaïque 100 selon des directions parallèles, chaque sous-cellule 200 comprend un bord à passiver ou deux bords parallèles à passiver. Le procédé d'activation thermique selon la figure 2 (balayage simple ou de type aller-retour) ou selon la figure 6 est avantageusement employé.

Comme illustré sur la figure 11C, les conditions du dépôt peuvent être choisies de façon à ce que la couche de passivation 210 recouvre en outre une bande 200d de la face impactée par le laser (la première face 200a dans l'exemple des figures 11A-11C). Cette bande est contiguë à la surface latérale additionnelle 200c' recouverte par la couche de passivation 210. Ainsi, les défauts créés par le laser dans la première face ou la deuxième face des sous-cellules 200, au voisinage des bords découpés, peuvent être neutralisés au même titre que les défauts présents sur la surface latérale additionnelle 200c'.

Le dépôt de la couche de passivation 210 sur la face impactée par le laser et sur la surface latérale 200c' est avantageusement réalisé en une seule fois (par exemple grâce aux techniques ALD ou SALD).

Lorsque la sous-cellule 200 comprend plusieurs surfaces latérales additionnelles 200c' et que plusieurs d'entre elles sont passivées à l'étape S2, la couche de passivation 210 recouvre avantageusement plusieurs bandes 200d de la face impactée par le laser, chaque bande 200d étant contiguë à l'une des surfaces latérales additionnelles 200c' passivées.

Le procédé d'activation et le procédé de fabrication de sous-cellules selon l'invention ne sont pas limités aux modes de mise en oeuvre décrits ci-dessus et de nombreuses variantes et modifications apparaîtront à l'homme du métier.

Il est notamment possible de passiver les quatre surfaces latérales 20c de la cellule photovoltaïque 20 en procédant à deux étapes d'exposition successives. Par exemple, une étape d'exposition peut utiliser une ligne 60 composée d'un segment de droite 61 (cf. Fig.2) pour passiver les bords d'attaque 21 et bord de fuite 22 (en effectuant au moins un aller-retour) et l'autre étape d'exposition peut utiliser une ligne 60 en forme de flèche (cf. Fig.2) pour passiver les deux bords transversaux 23-24 (supérieur et inférieur). Deux sources de rayonnement 40 pourront ainsi être prévues pour générer les deux types de ligne.

Par ailleurs, le balayage de la cellule photovoltaïque 20 par la ligne de rayonnement électromagnétique 60 (à la vitesse de balayage V) peut être obtenu par d'autres moyens qu'un mouvement relatif de translation entre la cellule photovoltaïque 20 et la source de rayonnement 40. La source de rayonnement 40 peut notamment être pivotante et la cellule photovoltaïque 20 immobile.

Enfin, à l'étape S1 du procédé de fabrication de sous-cellules (cf. Figs.11A-11B), les cellules photovoltaïques 100 de pleine taille peuvent être découpées grâce à une technique autre que la prédécoupe au laser suivie du clivage mécanique, par exemple par laser seul, avec ou sans séparation thermique induite par le laser et un éventuel refroidissement, par clivage mécanique seul ou par rainurage mécanique.

**Revendications**

1. Procédé d'activation thermique d'une couche de passivation (10) disposée sur une cellule photovoltaïque (20), la cellule photovoltaïque (20) comprenant une première face (20a), une deuxième face (20b) opposée à la première face et des surfaces latérales (20c) reliant les première et deuxième faces, la couche de passivation (10) recouvrant au moins une des surfaces latérales (20c) de la cellule photovoltaïque (20), le procédé comprenant une étape d'exposition de la première face (20a) à un rayonnement électromagnétique (30) émis par une source de rayonnement (40),

   **caractérisé en ce que** le rayonnement électromagnétique (30) est appliqué sur la première face (20a) selon une ligne (60), **en ce que** la ligne (60) balaye une partie au moins de la première face (20a), d'où il résulte une zone de surchauffe (71, 72) adjacente à un ou plusieurs bords de la première face (20a), et **en ce que** la ligne (60) est orientée par rapport à la première face (20a) de sorte que la zone de surchauffe (71, 72) englobe une partie au moins de la couche de passivation (10).

2. Procédé selon la revendication 1, dans lequel la cellule photovoltaïque (20) et la source de rayonnement (40) sont animées d'un mouvement relatif de translation.

3. Procédé selon l'une des revendications 1 et 2, dans lequel la première face (20a) comprend :

   - un premier bord (21) appelé bord d'attaque ;
   - un deuxième bord (22) appelé bord de fuite et opposé au premier bord (21) ; et
   - des troisième et quatrième bords (23, 24) reliant les premier et deuxième bords (21, 22).

4. Procédé selon la revendication 3, dans lequel :

   - la couche de passivation (10) recouvre la surface latérale (20c) bordée par le bord de fuite (22) ; et
   - la ligne (60) comprend un segment de droite (61) orienté perpendiculairement à une médiane (M) de la première face (20a), la médiane passant par le bord d'attaque (21) et le bord de fuite (22).

5. Procédé selon l'une des revendications 3 et 4, dans lequel :

   - la couche de passivation (10) comprend une première portion recouvrant la surface latérale (20c) bordée par le bord de fuite (22) et une deuxième portion recouvrant la surface latérale (20c) bordée par le bord d'attaque (21) ; et
   - la ligne (60) balaye la première face (20a) dans un premier sens lors d'une première phase et dans un deuxième sens opposé lors d'une deuxième phase.

6. Procédé selon la revendication 3, dans lequel :

   - la couche de passivation (10) comprend une première portion recouvrant la surface latérale (20c) bordée par le bord de fuite (22) et une deuxième portion recouvrant la surface latérale (20c) bordée par l'un des troisième et quatrième bords (23-24) ; et
   - la ligne (60) comprend un segment de droite (61') incliné par rapport à une médiane (M) de la première face d'un angle ($\alpha$) strictement inférieur à 90° en valeur absolue, la médiane (M) passant par le bord d'attaque (21) et le bord de fuite (22).

7. Procédé selon la revendication 3, dans lequel :

   - la couche de passivation (10) comprend une première portion recouvrant la surface latérale (20c) bordée par le troisième bord (23) et une deuxième portion recouvrant la surface latérale (20c) bordée par le quatrième bord (24) ; et
   - la ligne (60) est une ligne brisée comprenant un premier segment de droite (62a) incliné par rapport à une médiane (M) de la première face (20a) d'un premier angle positif ($\alpha_1$) et un deuxième segment de droite (62b) incliné par rapport à la médiane (M) d'un deuxième angle négatif ($\alpha_2$), la médiane (M) passant par le bord d'attaque (21) et le bord de fuite (22), le premier angle ($\alpha_1$) et le deuxième angle ($\alpha_2$) étant inférieurs à 90° en valeur absolue, de préférence inférieurs à 45° en valeur absolue.

8. Procédé selon la revendication 7, dans lequel le premier angle ($\alpha_1$) et le deuxième angle ($\alpha_2$) sont compris entre

10° et 20° en valeur absolue.

9. Procédé selon l'une des revendications 7 et 8, dans lequel le premier angle ($\alpha_1$) et le deuxième angle ($\alpha_2$) sont égaux en valeur absolue.

10. Procédé selon l'une quelconque des revendications 1 à 9, dans lequel la ligne (60) balaye toute la superficie de la première face (20a).

11. Procédé selon l'une quelconque des revendications 1 à 10, dans lequel la densité surfacique d'énergie (Q) reçue en tout point de la première face (20a) est comprise entre 1 kJ/m$^2$ et 1000 kJ/m$^2$, avantageusement entre 10 kJ/m$^2$ et 100 kJ/m$^2$.

12. Procédé selon l'une quelconque des revendications 1 à 11, dans lequel le rayonnement électromagnétique (30) présente une irradiance (E) supérieure ou égale à 1 kW/m$^2$, de préférence comprise entre 100 kW/m$^2$ et 5000 kW/m$^2$.

13. Procédé selon l'une quelconque des revendications 1 à 12, dans lequel la cellule photovoltaïque (20) et la source de rayonnement (40) sont en mouvement relatif de translation à une vitesse de déplacement (V) comprise entre 1 cm/s et 100 cm/s, de préférence supérieure ou égale à 2 cm/s.

14. Procédé selon l'une quelconque des revendications 1 à 13, dans lequel la ligne (60) présente une largeur (L) comprise entre 0,1 mm et 100 mm, de préférence comprise entre 1 mm et 10 mm.

15. Procédé de fabrication de sous-cellules photovoltaïques (200) passivées, comprenant les étapes suivantes :

- découper (S1) des cellules photovoltaïques (100) pour former une pluralité de sous-cellules photovoltaïques (200), chaque sous-cellule photovoltaïque comprenant une première face (200a), une deuxième face (200b) opposée à la première face (200a) et des surfaces latérales (200c, 200c') reliant les première et deuxième faces, au moins une (200c') des surfaces latérales de chaque sous-cellule photovoltaïque (200), dite additionnelle, résultant du découpage d'une cellule photovoltaïque (100) ;
- déposer (S2) une couche de passivation (210) sur au moins une surface latérale additionnelle (200c') des sous-cellules photovoltaïques (200) ;
- activer (S2) thermiquement la couche de passivation (210) des sous-cellules photovoltaïques (200) en suivant un procédé d'activation thermique selon l'une quelconque des revendications 1 à 14.

16. Procédé de fabrication selon la revendication 15, dans lequel les cellules photovoltaïques (100) sont découpées en demi-cellules (200) ou en sous-unités de superficie inférieure à celle d'une demi-cellule.

[Fig. 1]

[Fig. 2]

[Fig. 3]

[Fig. 4]

[Fig. 5]

[Fig. 6]

[Fig. 7]

[Fig. 8A]

[Fig. 8B]

[Fig. 9]

EP 4 199 118 A1

[Fig. 10]

[Fig. 11A]

-S1(F1)-

[Fig. 11B]

-S1(F2)-

200a   110  120   200c'   120   110  200a

200c   200

200   200c

200c   200b   200b

[Fig. 11C]

200d

-S2-

200a  120

200c'   200c

210   200

200b

**EP 4 199 118 A1**

Europäisches
Patentamt

European
Patent Office

Office européen
des brevets

**RAPPORT DE RECHERCHE EUROPEENNE**

Numéro de la demande

**EP 22 21 5066**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2021/018757 A1 (COMMISSARIAT ENERGIE ATOMIQUE [FR]) 4 février 2021 (2021-02-04) * abrégé; figures 1,2 * * alinéas [0046], [0051], [0055], [0056] * | 1-5, 10-16 | INV. H01L31/0216 H01L31/18 |
| A | WO 2020/127896 A1 (COMMISSARIAT ENERGIE ATOMIQUE [FR]; CENTRE NAT RECH SCIENT [FR] ET AL.) 25 juin 2020 (2020-06-25) * abrégé; figures 1A-1C * | 1,4,5 | |
| A | WO 2020/220079 A1 (NEWSOUTH INNOVATIONS PTY LTD [AU]) 5 novembre 2020 (2020-11-05) * abrégé * * Section "Summary" * | 1,4,5 | |
| X | KR 101 424 538 B1 (NCD CO [KR]; KIM JONG HWAN [KR]) 4 août 2014 (2014-08-04) * abrégé * * alinéa [0014] * | 1 | |
| X | EP 2 472 601 A2 (BP CORP NORTH AMERICA INC [US]) 4 juillet 2012 (2012-07-04) * abrégé * * alinéa [0059] * | 1 | DOMAINES TECHNIQUES RECHERCHES (IPC) H01L |
| X | US 2010/124619 A1 (XU BAOMIN [US] ET AL) 20 mai 2010 (2010-05-20) * abrégé * * alinéa [0050] * | 1 | |
| X | CN 111 162 143 A (GUANGDONG AIKO TECH CO LTD) 15 mai 2020 (2020-05-15) * abrégé * * Etape S5 * | 1 | |

Le présent rapport a été établi pour toutes les revendications

| Lieu de la recherche | Date d'achèvement de la recherche | Examinateur |
|---|---|---|
| Berlin | 12 avril 2023 | Favre, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................
& : membre de la même famille, document correspondant

EPO FORM 1503 03.82 (P04C02)

**EP 4 199 118 A1**

## ANNEXE AU RAPPORT DE RECHERCHE EUROPEENNE
## RELATIF A LA DEMANDE DE BREVET EUROPEEN NO.

EP 22 21 5066

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-04-2023

| Document brevet cité au rapport de recherche | Date de publication | Membre(s) de la famille de brevet(s) | Date de publication |
|---|---|---|---|
| WO 2021018757 A1 | 04-02-2021 | CN 114503289 A | 13-05-2022 |
| | | EP 4004986 A1 | 01-06-2022 |
| | | FR 3099294 A1 | 29-01-2021 |
| | | US 2022246774 A1 | 04-08-2022 |
| | | WO 2021018757 A1 | 04-02-2021 |
| WO 2020127896 A1 | 25-06-2020 | CN 113330585 A | 31-08-2021 |
| | | EP 3900052 A1 | 27-10-2021 |
| | | FR 3091025 A1 | 26-06-2020 |
| | | WO 2020127896 A1 | 25-06-2020 |
| WO 2020220079 A1 | 05-11-2020 | TW 202111965 A | 16-03-2021 |
| | | WO 2020220079 A1 | 05-11-2020 |
| KR 101424538 B1 | 04-08-2014 | AUCUN | |
| EP 2472601 A2 | 04-07-2012 | EP 2472601 A2 | 04-07-2012 |
| | | WO 2012054426 A2 | 26-04-2012 |
| US 2010124619 A1 | 20-05-2010 | AUCUN | |
| CN 111162143 A | 15-05-2020 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- WO 2020127896 A
- WO 2020220079 A

**Littérature non-brevet citée dans la description**

- **D. K. SIMON et al.** Low-thermal budget flash light annealing for Al2O3 surface passivation. *Physica status solidi (RRL) - Rapid Research Letters,* 2015, vol. 9 (11), 631-635